# EUROPEAN PATENT SPECIFICATION

(11) **EP 3 786 991 B1**
(45) Date of publication and mention of the grant of the patent: **24.05.2023**
(21) Application number: 19929180.8
(22) Date of filing: 29.05.2019
(51) Int. Cl.: H01G 4/005, H01G 4/012, H01G 4/33, H10N 97/00

(54) **CAPACITOR AND PREPARATION METHOD THEREFOR**
KONDENSATOR UND HERSTELLUNGSVERFAHREN DAFÜR
CONDENSATEUR ET SON PROCÉDÉ DE PRÉPARATION

(43) Date of publication of application: 03.03.2021
(73) Proprietor: SHENZHEN GOODIX TECHNOLOGY CO., LTD., Shenzhen, Guangdong 518045 (CN)
(72) Inventor: LU, Bin, Shenzhen, Guangdong 518045 (CN); SHEN, Jian, Shenzhen, Guangdong 518045 (CN)
(74) Representative: Pfenning, Meinig & Partner mbB
(86) International application number: PCT/CN2019/089119
(87) International publication number: WO 2020/237543

(56) References cited:
- WO-A2-2015/192096
- CN-A- 103 456 497
- CN-A- 109 075 164
- CN-A- 109 585 161
- JP-A- 2010 045 297
- JP-A- 2010 045 297
- US-A1- 2010 196 592
- US-A1- 2016 020 267
- US-A1- 2016 315 138
- US-A1- 2017 263 695
- US-A1- 2019 103 227

## Description

### TECHNICAL FIELD

The present application relates to the field of capacitors, and more particularly, to a capacitor and a producing method therefor.

### BACKGROUND

A capacitor can play a role of bypassing, filtering, decoupling, or the like in a circuit, which is an indispensable part for ensuring a normal operation of the circuit. However, as modern electronic systems continue to develop towards multi-functions, high integration, low power consumption and microminiaturization, the existing capacitor manufacturing techniques are already difficult to meet diverse needs of various high-end applications.

Therefore, how to improve capacitance density of a capacitor is a technical problem to be solved urgently.

US20190103227A1 discloses capacitor structures. The capacitor structure includes a substrate, and a first electrode disposed on the substrate, the first electrode including a conductive layer, a first conductive post electrically connected to the conductive layer and a second conductive post electrically connected to the conductive layer. The capacitor structure further includes a planarization layer disposed on and covering the first electrode, the planarization layer disposed in a space between the first conductive post and the second conductive post, a first dielectric layer disposed on the planarization layer and in the space between the first conductive post and the second conductive post, and a second electrode disposed on the first dielectric layer.

WO2015192096A2 discloses making multilayer 3D capacitors using arrays of upstanding rods or ridges. In accordance with the present invention, novel methods are provided for making high capacitance, 3D, multilayer or Metal-Insulator-Metal (MIM) capacitors on or in an associated substrate that overcome the above and other drawbacks of the prior art.

JP2010045297A discloses trench type capacitor and method of manufacturing the same. To provide a trench type capacitor for sufficiently improving productivity and reliability by improving the mechanical strength of a whole component.

US2010196592A1 discloses methods of fabricating capacitors including low-temperature capping layers. In a method of fabricating a capacitor, a lower electrode is formed, and a dielectric layer is formed on the lower electrode. An upper electrode is foamed on the dielectric layer opposite the lower electrode. A low-temperature capping layer is formed on the upper electrode at a temperature of less than about 3000 C. Related devices and fabrication methods are also discussed.

US2016315138A1 discloses high density capacitor structure and method. High density capacitor structures based on an array of semiconductor nanorods are provided. The high density capacitor structure can be a plurality of capacitors in which each of the semiconductor nanorods serves as a bottom electrode for one of the plurality of capacitors, or a largearea metal-insulator-metal (MIM) capacitor in which the semiconductor nanorods serve as a support structure for a bottom electrode of the MIM capacitor subsequently formed.

US2016020267A1 discloses low impedance high density deep trench capacitor. Some embodiments relate to high density capacitor structures. Some embodiments include a first trench capacitor, a second trench capacitor and an interconnect structure. The first trench capacitor includes a first capacitor plate disposed in a plurality of trenches in a semiconductor substrate, and a second capacitor plate disposed in the plurality of trenches and separated from the first capacitor plate by a first capacitor dielectric along bottom and sidewall surfaces of the plurality of trenches. The second trench capacitor is disposed over the first trench capacitor. The second trench capacitor includes the second capacitor plate, and a third capacitor plate disposed in the plurality of trenches and separated from the second capacitor plate by a second capacitor dielectric. The interconnect structure connects the first capacitor plate and the third capacitor plate such that the first and second trench capacitors are in parallel.

### SUMMARY

The present invention provides a capacitor and a producing method therefor according to the appended claims.

In a first aspect, a capacitor is provided, including:
a first electrode and a second electrode respectively configured to connect an external circuit;
at least one support, the at least one support being a wall-shaped structure;
a laminated structure including at least one dielectric layer and at least one conductive layer; the at least one dielectric layer and the at least one conductive layer covering the at least one support, and the at least one dielectric layer and the at least one conductive layer forming a structure that a dielectric layer and a conductive layer are adjacent to each other; and
an interconnection structure configured to electrically connect the first electrode to the at least one support or a first conductive layer of the at least one conductive layer, and to electrically connect the second electrode to a second conductive layer of the at least one conductive layer, where the second conductive layer is connected to the at least one support or the first conductive layer electrically connected to the first electrode through a dielectric layer of the at least one dielectric layer.
a base layer, the base layer and the at least one support forming at least one groove structure, the base layer serving as a bottom of the at least one groove structure, the at least one support serving as a side wall of the at least one groove structure, and the laminated structure covering the at least one groove structure;
the base layer is provided with at least one opening, the at least one support is provided in the at least one opening, and a lower surface of the base layer and a lower surface of the at least one support are located in a same plane.

In a second aspect, a method for producing a capacitor is provided, including:
forming the base layer on the substrate, producing at least one support on the base layer, the at least one support being a wall-shaped structure;
forming the at least one opening in the base layer, the at least one support is provided in the at least one opening, and a lower surface of the base layer and a lower surface of the at least one support are located in a same plane;
producing at least one dielectric layer and at least one conductive layer on the at least one support to obtain a laminated structure, where the at least one dielectric layer and the at least one conductive layer form a structure that a dielectric layer and a conductive layer are adjacent to each other;
producing an insulating structure including an interconnection structure on the laminated structure; and
producing a first electrode and a second electrode on the insulating structure, where the first electrode is electrically connected to the at least one support or a first conductive layer of the at least one conductive layer, and the second electrode is electrically connected to a second conductive layer of the at least one conductive layer; and the second conductive layer is connected to the at least one support or the first conductive layer electrically connected to the first electrode through a dielectric layer of the at least one dielectric layer.

Based the foregoing technical solutions, a capacitor is formed using a laminated structure that a conductive layer and a dielectric layer are alternately stacked, which could obtain a great capacitance value in a case of a small device size, thereby improving capacitance density of the capacitor. In addition, by producing the laminated structure on the at least one support and serving the at least one support as one electrode plate of the capacitor, a structure of the capacitor may be simplified.

### BRIEF DESCRIPTION OF DRAWINGS

FIG. 1 is a schematic structural diagram of a capacitor according to an embodiment of the present application.
FIG. 2 is a schematic structural diagram of a substrate having a conductive zone according to an embodiment of the present application.
FIG. 3 is another schematic structural diagram of a substrate having a conductive zone according to an embodiment of the present application.
FIG. 4 is another schematic structural diagram of a capacitor according to an embodiment of the present application.
FIG. 5 is a schematic flow chart of a method for producing a capacitor according to an embodiment of the present application.
FIG. 6 to FIG. 17 are schematic process flow charts for producing the capacitor shown in FIG. 1.
FIG. 18 to FIG. 27 are schematic process flow charts for producing the capacitor shown in FIG. 2.
FIG. 28 and FIG. 29 are other schematic structural diagrams of the structure shown in FIG. 10.

### DESCRIPTION OF EMBODIMENTS

Technical solutions in embodiments of the present application will be described hereinafter with reference to accompanying drawings.

It should be understood that a capacitor of an embodiment of the present application can play a role of bypassing, filtering, decoupling, or the like in a circuit.

The capacitor described in the embodiment of the present application may be a 3D silicon capacitor, which may be a capacitor processed using semiconductor wafer processing techniques.

Compared with a multilayer ceramic capacitor (MLCC), the 3D silicon capacitor has advantages of small size, high precision, strong stability, long lifetime, and the like. In a processing flow for the 3D silicon capacitor, a 3D structure with a high aspect ratio, such as a via, a trench, a pillar shape, or a wall shape, is required to be first processed on a wafer or substrate, and then an insulating thin film and a low-resistivity conductive material are deposited on a surface of the 3D structure to manufacture a lower electrode, a dielectric layer and an upper electrode of the capacitor, sequentially.

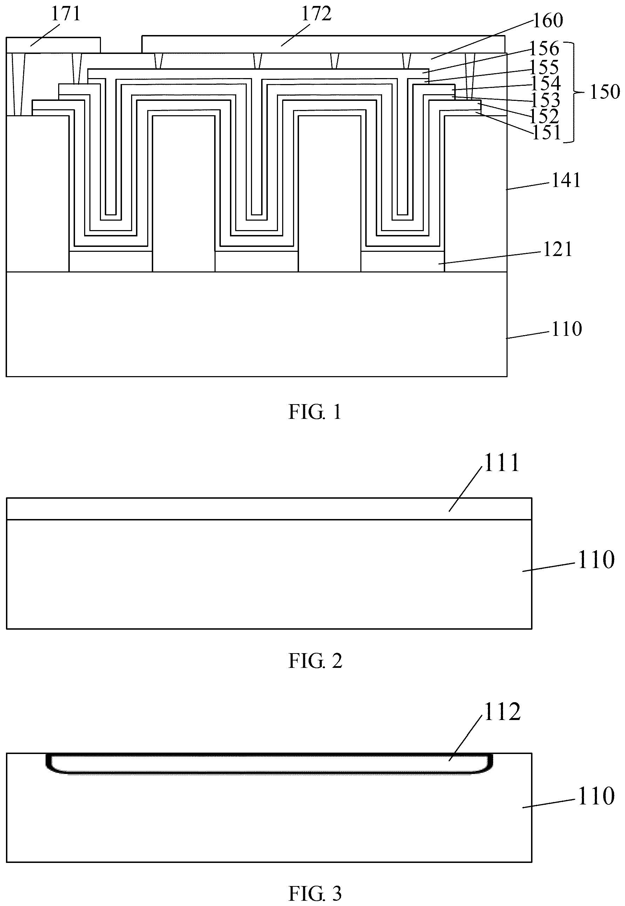

A capacitor and a producing method for the same according to embodiments of the present application will be introduced in detail hereinafter with reference to FIG. 1 to FIG. 29.

It should be noted that, in the embodiments of the present application, same reference numerals represent same components for convenience of description, and detailed description of the same components is omitted in different embodiments for brevity. It should be understood that dimensions such as thicknesses, lengths and widths of various components in the embodiments of the present application shown in the drawings, as well as dimensions such as the overall thickness, length and width of an integrated apparatus are merely illustrative, and should not constitute any limitation on the present application.

In addition, in embodiments shown below, for structures shown in different embodiments, same structures are denoted by same reference numerals for ease of understanding, and detailed description of the same structures is omitted for brevity.

FIG. 1 is a schematic structural diagram of a capacitor 100 according to an embodiment of the present application.

With reference to FIG. 1, the capacitor 100 may include a first electrode 171, a second electrode 172, at least one support, a laminated structure 150 and an interconnection structure.

The first electrode 171 and the second electrode 172 are positive and negative electrodes of the capacitor 100, respectively. The first electrode 171 and the second electrode 172 are separate from each other. Materials of the first electrode 171 and the second electrode 172 may be various conductive materials, such as a metal of aluminum. The first electrode 171 and the second electrode 172 may be implemented in the form of a pad or a solder ball. The first electrode 171 and the second electrode 172 may be respectively configured to externally connect an element or an apparatus, such as another circuit or chip.

The at least one support is a wall-shaped structure.

That is, a 3D structure of each of the at least one support is a wall.

A length of the wall in a first horizontal axis direction may be greater than (or less than) a length of the wall in a second horizontal axis direction. The first horizontal axis direction is perpendicular to the second horizontal axis direction. Similar to the pillar-shaped structure, arrises and dimensions of the wall are not specifically limited in the present application.

Optionally, the at least one support may be a plurality of conductive supports electrically connected to each other.

In one implementation, the plurality of supports are physically connected. For example, the plurality of supports are a plurality of walls crisscrossed. That is, in a top view, the plurality of supports form a "#"-shaped structure or a grid structure. In another implementation, the plurality of supports are physically separate. For example, the plurality of supports are a plurality of pillars distributed in an array. In this case, the plurality of supports may be electrically connected through another element. For example, bottoms of the plurality of supports are connected through a conductive layer or a wire.

With continuing reference to FIG. 1, optionally, the laminated structure 150 may include at least one dielectric layer (also referred to as an insulating layer) and at least one conductive layer.

The at least one dielectric layer and the at least one conductive layer cover the at least one support, and the at least one dielectric layer and the at least one conductive layer form a structure that a dielectric layer and a conductive layer are adjacent to each other.

That is, a layer in the laminated structure 150 adjacent to a conductive layer is a dielectric layer, and a layer in the laminated structure 150 adjacent to a dielectric layer is a conductive layer. In other words, layers above and under a conductive layer in the laminated structure 150 are dielectric layers, and layers above and under a dielectric layer in the laminated structure 150 are conductive layers.

Optionally, a layer in the laminated structure 150 closest to the at least support may be a dielectric layer.

That is, the at least one support is in direct contact with a dielectric layer in the laminated structure 150. In other words, a bottom layer of the laminated structure is a dielectric layer, and a lower surface of the dielectric layer is in direct contact with an upper surface of the at least one support.

Optionally, a layer in the laminated structure 150 closest to the at least support may be a conductive layer.

That is, the at least one support is in direct contact with a conductive layer in the laminated structure 150. In other words, a bottom layer of the laminated structure is a conductive layer, and a lower surface of the conductive layer is in direct contact with an upper surface of the at least one support.

Optionally, the at least one support may be at least one conductive support or at least one insulating support, which is not specifically limited in the present application.

In an example that the at least one support is a conductive support and the bottom layer of the laminated structure 150 is a dielectric layer, with reference to FIG. 1, the at least one support includes four supports 141; the at least one dielectric layer in the laminated structure 150 includes dielectric layers 151, 153 and 155; and the at least one conductive layer in the laminated structure 150 includes conductive layers 152, 154 and 156. The bottom layer of the laminated structure 150 is the dielectric layer 151.

Optionally, at least one first step and at least one second step may be respectively formed at two ends of the laminated structure 150. For example, the two ends of the laminated structure are respectively provided above the at least one support.

With reference to FIG. 1, the two ends of the laminated structure 150 are respectively provided above supports on two sides of the four supports. The dielectric layer 151 is aligned with the conductive layer 152, the dielectric layer 153 is aligned with the conductive layer 154, and the dielectric layer 155 is aligned with the conductive layer 156. Thus, the conductive layer 152, the conductive layer 154 and the conductive layer 156 form step structures to be electrically connected with the first electrode 171 or the second electrode 172.

Optionally, an aspect ratio of the at least one support is greater than a certain threshold value to ensure that the laminated structure 150 has a sufficient surface area. Optionally, the at least one support may be a plurality of supports with different aspect ratios.

Optionally, spacing between two adjacent supports of the plurality of supports is greater than a certain threshold value, such as a width of one support, to ensure that the spacing between the two adjacent supports could accommodate the laminated structure 150. Further, the spacing between the two adjacent supports may be less than a certain threshold value, such as a width of two supports, to ensure that the laminated structure 150 has a sufficient surface area.

To sum up, by setting an aspect ratio of each support and spacing between two adjacent supports, a surface area of a conductive layer in the laminated structure 150 may be controlled. In other words, by forming a laminated structure on a support (such as a support in a wall-shaped structure) with high density and a high aspect ratio, a surface area of an electrode plate and density of stacked layers may be increased, thereby forming a capacitor 100 with a small size and a high capacity.

In addition, the four supports 141 are reused as an electrode plate of the capacitor 100, which could simplify a structure of the capacitor 100.

With reference to FIG. 1, the four supports 141 electrically connected serve as a layer of electrode plate. The dielectric layer 151, the conductive layer 152, the dielectric layer 153, the conductive layer 154, the dielectric layer 155 and the conductive layer 156 are formed on the four supports 141 in a stacking manner, sequentially, and the laminated structure 150 may be obtained. Further, the four supports 141 serve as a layer of electrode plate to form a first capacitor with the dielectric layer 151 and the conductive layer 152. The conductive layer 152, the dielectric layer 153 and the conductive layer 154 may be configured to form a second capacitor. The conductive layer 154, the dielectric layer 155 and the conductive layer 156 may be configured to form a third capacitor. The four supports 141 and the conductive layer 154 are electrically connected to the first electrode 171, and the foregoing conductive layer 152 and the conductive layer 156 are connected to the second electrode 172, thereby realizing that the foregoing first capacitor, the foregoing second capacitor and the foregoing third capacitor are connected in parallel, and further obtaining a capacitor with a large capacitance value.

The interconnection structure is configured to respectively connect the first electrode 171 and the second electrode 172 at least to two adjacent electrode plates to ensure that the capacitor 100 could realize a basic function of a capacitor, that is, to accommodate charges.

For example, the interconnection structure may be configured to electrically connect the first electrode 171 to the at least one support or a first conductive layer of the laminated layer 150, and to electrically connect the second electrode 172 to a second conductive layer of the laminated layer 150. The second conductive layer is adjacent to the at least one support or the first conductive layer which is electrically connected to the first electrode 171. For example, the second conductive layer is connected to the at least one support or the first conductive layer electrically connected to the first electrode 171 through a dielectric layer of the at least one dielectric layer.

That is, when the first electrode 171 is electrically connected to the at least one conductive support, the second conductive layer is adjacent to the at least one conductive layer; and when the first electrode 171 is electrically connected to the first conductive layer, the second conductive layer is adjacent to the first conductive layer.

For example, when the at least one support is at least one conductive support, the interconnection structure may be configured to electrically connect the first electrode 171 to the at least one conductive support and/or some or all even-numbered conductive layer(s) in the laminated structure 150, and to electrically connect the second electrode 172 to some or all odd-numbered conductive layer(s) in the laminated structure 150, so as to connect a plurality of capacitors in the laminated structure 150 in parallel to the greatest extent. For example, when the at least one support is at least one conductive layer and a bottom layer of the laminated structure 150 is a dielectric layer, the interconnection structure may be configured to electrically connect the first electrode 171 to the at least one conductive support and all even-numbered conductive layer(s) in the laminated structure 150, and to electrically connect the second electrode 172 to all odd-numbered conductive layer(s) in the laminated structure 150. For another example, when the at least one support is at least one conductive layer and a bottom layer of the laminated structure 150 is a conductive layer, the interconnection structure may be configured to electrically connect the first electrode 171 to all even-numbered conductive layer(s) in the laminated structure 150, and to electrically connect the second electrode 172 to all odd-numbered conductive layer(s) in the laminated structure 150.

For another example, when the at least one support is at least one insulating support, the interconnection structure may be configured to electrically connect the first electrode 171 to some or all even-numbered conductive layer(s) in the laminated structure 150, and to electrically connect the second electrode 172 to some or all odd-numbered conductive layer(s) in the laminated structure 150.

It should be noted that an order of conductive layers involved in the present application may be an order from one side of the laminated structure 150 to another side, such as an order from top to bottom or an order from bottom to top. For ease of description, description will be made by an example of an order from bottom to top.

With reference to FIG. 1, the conductive layers 152, 154 and 156 in the laminated structure 150 are the first to third conductive layers, respectively. An even-numbered conductive layer may be the second conductive layer (that is, the conductive layer 154), and the four supports 141 and the conductive layer 154 may be electrically connected to the first electrode 171 through the interconnection structure. Odd-numbered conductive layers may be the first conductive layer (that is, the conductive layer 152) and the third conductive layer (that is, the conductive layer 156), and the conductive layer 152 and the conductive layer 156 may be electrically connected to the second electrode 172 through the interconnection structure.

A material of the interconnection structure may be various conductive materials, and may be the same as or different from a material of a conductive layer in the laminated structure 150. For example, it may be titanium nitride and a metal of tungsten.

The capacitor 100 further includes a base layer.

The base layer and the at least one support form at least one groove structure, the base layer serves as a bottom of the at least one groove structure, the at least one support serves as a side wall of the at least one groove structure, and the laminated structure covers the at least one groove structure.

With continuing reference to FIG. 1, the base layer 121 is provided with at least one opening, the four supports 141 are provided in the at least one opening, and a lower surface of the base layer 121 and lower surfaces of the four supports 141 are located in a same plane.

A material of the base layer 121 is an insulating material.

When the material of the base layer 121 is an insulating material, the base layer 121 may prevent occurrence of electric breakdown between a substrate 110 and the laminated structure 150 to improve performance of the capacitor 100.

With continuing reference to FIG. 1, the capacitor 100 may further include an insulating layer 160.

The insulating layer 160 is used to clad the laminated structure 150 to protect the laminated structure 150 and reduce interference between the laminated structure 150 and another external circuit.

The insulating layer 160 may cover at least an upper part of the laminated structure 150 and two sides of the laminated structure 150. For example, the insulating layer 160 covers at least the upper part of the laminated structure 150 and steps formed at two ends of the laminated structure 150.

The interconnection structure may further include at least one first via and at least one second via.

That is, the insulating layer 160 includes at least one first via and at least one second via, the first electrode 171 is electrically connected to the at least one support or the first conductive layer through the at least first via, and the second electrode 172 is electrically connected to the second conductive layer through the at least one second via.

It should be understood that the at least one first via and the at least one second via may be filled with a conductive material that is the same as or different from the material of the conductive layer in the laminated structure 150, or wiring layers for electrical connection are arranged in the at least one first via and the at least one second via so that the first electrode 171 and the second electrode 172 are respectively electrically connected to corresponding conductive layers or supports through the conductive material or wiring layers in the vias. The present application is not limited thereto.

With continuing reference to FIG. 1, the capacitor 100 may further include a substrate 110.

The substrate 110 is provided under the laminated structure 150 to support the at least one support and the base layer. The substrate 110 may be further configured to electrically connect the foregoing at least one support.

Optionally, the substrate 110 may be a low-resistivity monocrystalline silicon wafer.

Certainly, the substrate 110 may be a semiconductor substrate, a glass substrate or an organic substrate provided with a low-resistivity conductive layer on a surface to ensure conductivity of the foregoing plurality of supports. For example, with reference to FIG. 2, an upper surface of the substrate 110 may be provided with a conductive zone 111 with a resistivity lower than a preset threshold value. For another example, which does not form part of the invention, with reference to FIG. 3, an upper surface of the substrate 110 extends downward to form a groove, and a conductive material with a resistivity lower than the preset threshold value is provided in the groove of the substrate to form the conductive zone 112.

A material of the semiconductor substrate may be silicon, germanium or an III-V group element (silicon carbide (SiC), gallium nitride (GaN), gallium arsenide (GaAs), or the like), or may be a combination of the foregoing different materials. The semiconductor substrate may further include an epitaxial layer structure of the substrate for insulating the substrate, such as a silicon-on-insulator (SOI) structure. The substrate 110 may be a whole wafer or a part cut from a wafer.

The low-resistivity conductive layer may be heavily doped silicon, metal, TiN, TaN, carbon or conductive organic matter. The low-resistivity conductive layer may be a conductive layer with a resistivity lower than a preset threshold value. The preset threshold value is set so that the at least one support could serve as one electrode plate of the capacitor 100 after a bottom thereof is electrically connected.

It should be understood that FIG. 1 to FIG. 3 are merely examples of the capacitor of the present application and should not be understood as a limitation on the present application. For example, the two ends of the laminated structure 150 may also be respectively provided on two sides of the at least one support.

For example, the number of the at least one support may be greater than four or less than four, which is not specifically limited in the embodiment of the present application.

For another example, various layers in the laminated structure 150 may be aligned in another manner, which is not specifically limited in the present application. For example, each layer in the laminated structure 150 may not be aligned with another layer. That is, steps are respectively formed between layers of the dielectric layer 151, the conductive layer 152, the dielectric layer 153, the conductive layer 154, the dielectric layer 155 and the conductive layer 156.

For another example, the vias in the capacitor 100 only penetrate the insulating layer 160. Alternatively, when the dielectric layer 153 is aligned with the conductive layer 152, a second via between the conductive layer 152 and the second electrode 172 needs to penetrate the dielectric layer 153.

For another example, the first electrode 171 may be electrically connected to only the four supports 141, and in this case, the second electrode 172 may be electrically connected to only the conductive layer 152. The first electrode may also be electrically connected to only the conductive layer 154, and in this case, the second electrode may be electrically connected to only the conductive layer 152 and/or the conductive layer 156. This is not limited in the embodiment of the present application. In other words, in the embodiment of the present application, a capacitance value of the capacitor 100 may be controlled by controlling connection objects of the first electrode 171 and the second electrode 172. Further, the first electrode 171 and the second electrode 172 may respectively include a plurality of electrodes. In this case, a capacitor 100 with a variable capacitance value may be formed by controlling a connection object of each electrode.

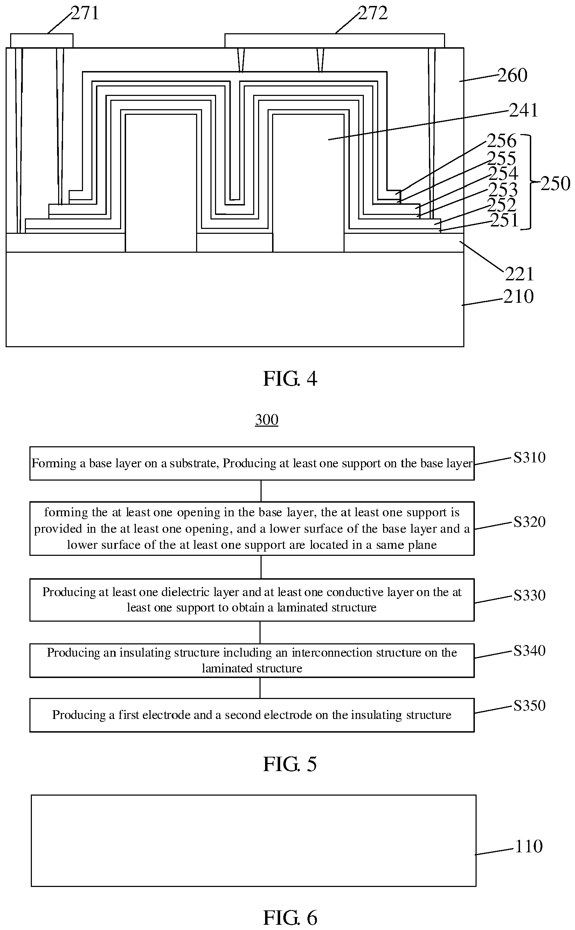

FIG. 4 is another schematic block diagram of a capacitor 200 according to an embodiment of the present application.

With reference to FIG. 4, the capacitor 200 may include a first electrode 271, a second electrode 272, two supports 241, a laminated structure 250 and an interconnection structure.

The laminated structure 250 may include a dielectric layer 251, a conductive layer 252, a dielectric layer 253, a conductive layer 254, a dielectric layer 255 and a conductive layer 256.

With continuing reference to FIG. 4, the capacitor 200 may further include a base layer 221 to support the laminated structure 250 and/or electrically connect the foregoing two supports 251. Further, the capacitor 200 may further include a substrate 210 to support the foregoing base layer 221 and/or the foregoing two supports 251. The substrate 210 may be further configured to electrically connect the foregoing two supports 251. Further, the capacitor 200 may further include an insulating layer 260 to protect the laminated structure 250 and reduce interference between the laminated structure 250 and another external circuit.

It should be understood that, since the capacitor 200 may be understood as a variation structure of the capacitor 100, to avoid repetition, the corresponding relevant description is omitted here, for example, materials of the corresponding conductive layers and dielectric layers, the corresponding working principle and the corresponding variation structure.

With continuing reference to FIG. 4, two ends of the laminated structure 250 may be further respectively provided on two sides of the foregoing two supports 241. That is, two ends of the substrate 210 are the base layer 221, one end of the laminated structure 250 is provided above the base layer 221 on the right side of the two supports 241, and another end of the laminated structure 250 is provided above the base layer 221 on the left side of the two supports. It can be seen that, in the capacitor 100, positions of the two ends of the laminated structure 150 are located on the supports, while in the capacitor 200, positions of the two ends of the laminated structure 250 are located on the base layer 221. In a specific implementation, a corresponding implementation manner may be selected according to actual needs of a capacitance value or requirements of a processing process, which is not specifically limited in the embodiment of the present application.

It should be understood that FIG. 1 to FIG. 4 are merely examples of the present application and should not be understood as a limitation on the present application.

For example, when a material of the base layer 221 is an insulating material, a via between the first electrode 271 and the base layer 221 may be replaced with a via penetrating the insulating layer 260 and the base layer 221.

For another example, the at least one support may be replaced with at least one insulating support, that is, the laminated structure is provided above the at least one insulating support. Further, a bottom layer of the laminated structure is a conductive layer. The first electrode and the second electrode are respectively electrically connected at least to two adjacent conductive layers in the laminated structure.

It should be understood that preferred embodiments of the present application have been described above in detail with reference to the accompanying drawings. However, the present application is not limited to specific details of the foregoing embodiments. Many simple modifications may be made to the technical solution of the present application within the scope of the technical concept of the present application, and these simple modifications all fall within the scope of protection of the present application.

The present application further provides a method for producing the capacitor 100 and the capacitor 200.

FIG. 5 is a schematic process flow chart of a method 300 for producing a capacitor according to an embodiment of the present application.

As shown in FIG. 5, the method 300 may include:
S310, forming a base layer on a substrate, producing at least one support on the base layer, the at least one support being a wall-shaped structure;
S320, forming the at least one opening in the base layer, the at least one support is provided in the at least one opening, and a lower surface of the base layer and a lower surface of the at least one support are located in a same plane;
S330, producing at least one dielectric layer and at least one conductive layer on the at least one support to obtain a laminated structure, where the at least one dielectric layer and the at least one conductive layer form a structure that a dielectric layer and a conductive layer are adjacent to each other;
S340, producing an insulating structure including an interconnection structure on the laminated structure; and
S350, producing a first electrode and a second electrode on the insulating structure, where the first electrode is electrically connected to the at least one support or a first conductive layer of the at least one conductive layer through the interconnection structure, and the second electrode is electrically connected to a second conductive layer through the interconnection structure; and the second conductive layer is connected to the at least one support or the first conductive layer electrically connected to the first electrode.

In an example that the at least one conductive layer is three plate layers, the at least one support is first produced on a surface of the substrate. Then, a first capacitor is provided on the at least one support, and contains a first plate layer (that is, the at least one support), a first dielectric layer and a second plate layer, where the first dielectric layer electrically isolates the first plate layer from the second plate layer. Next, a second capacitor is provided on the first capacitor, and contains the second plate layer, a second dielectric layer and a third plate layer, where the second dielectric layer electrically isolates the second plate layer from the third plate layer. Finally, an insulating structure is provided on the third plate layer, and an interconnection structure and pads are provided on the insulating structure, where at least one pad is electrically connected to the first plate layer and the third plate layer through the interconnection structure, and at least one pad is electrically connected to the second plate layer through the interconnection structure, thereby realizing that the first capacitor, the second capacitor and a third capacitor are connected in parallel, and further obtaining a capacitor with a large capacitance value.

A method for producing the capacitor 100 will be exemplarily described hereinafter with reference to FIG. 6 to FIG. 17.

The method for producing the capacitor 100 may include some or all of the following steps.

Step 0:
a substrate is selected, such as a low-resistivity monocrystalline silicon wafer shown in FIG. 6.

Certainly, a substrate 110 may be a semiconductor substrate, a glass substrate or an organic substrate provided with a low-resistivity conductive layer on a surface to ensure conductivity of the foregoing plurality of supports. This is not limited in the embodiment of the present application.

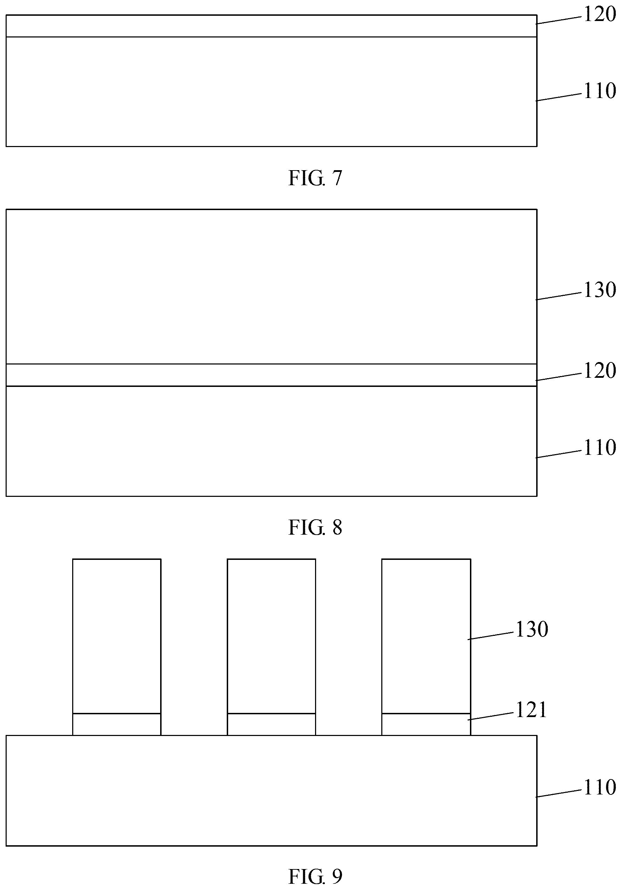

Step 1:
a base layer 120 is formed on the substrate 110 to form a structure shown in FIG. 7. A material of the base layer 120 may be an insulating material. For example, the base layer 120 may be silicon dioxide prepared using a thermal oxidation process, or silicon oxide, silicon nitride, silicon oxynitride, or silicon-containing glass (such as USG, BSG, PSG, and BPSG) deposited using a CVD process, or SOG or an organic material prepared using a spin-coating process.

Step 2:
the molding layer 130 is formed on the base layer 120 to form a structure shown in FIG. 8. The molding layer 130 may be polysilicon, amorphous silicon, silicon oxide, silicon nitride, silicon oxynitride, TEOS, or silicon-containing glass (USG, BSG, PSG, or BPSG) deposited using a CVD process, or SOG or an organic material prepared using a spin-coating process.

It should be noted that the molding layer 130 may be selectively removed with respect to the base layer 120.

Step 3:
at least one groove penetrating the molding layer 130 and the base layer 120 is formed to form a structure shown in FIG. 9. For example, the at least one groove may be manufactured in the base layer 120 and the molding layer 130 using a photolithography process combined with dry etching.

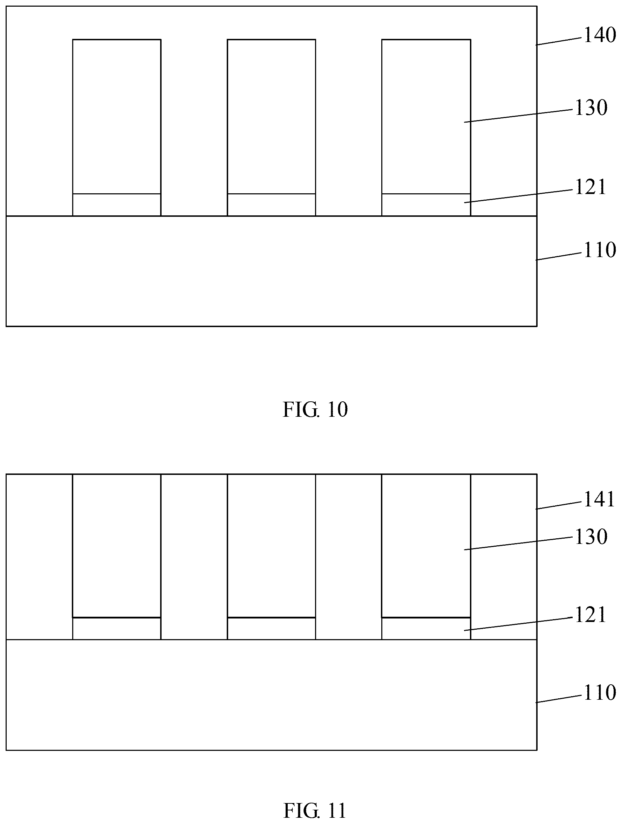

Step 4:
the at least one groove is filled with a conductive material 140 to form a structure shown in FIG. 10. For example, the conductive material 140 may be deposited using an ALD process and completely fill the at least one groove.

It should be noted that the conductive material 140 may be selectively removed with respect to the base layer 120.

Step 5:
a conductive material 140 above the molding layer 130 is removed to form a structure shown in FIG. 11. For example, the conductive material 140 above the molding layer 130 may be removed using a dry etching process to expose the molding layer 130.

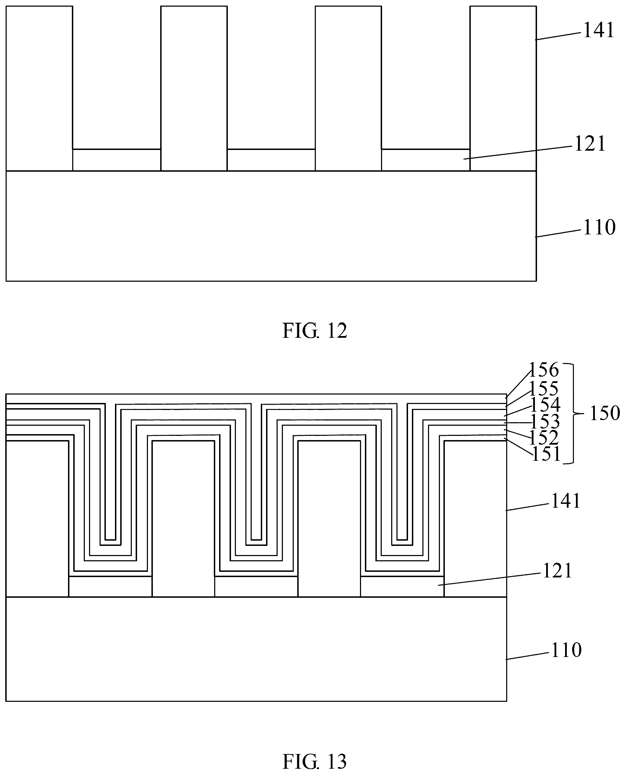

Step 6:
the molding layer 130 above the substrate 110 is removed to form the at least one support 141, thereby forming a structure shown in FIG. 12. For example, when a material of the molding layer 130 is USG and the materials of the base layer 120 and the conductive material 140 are TiN, the USG may be selectively removed using a hydrofluoric acid solution, thereby obtaining a TiN upright post embedded in the base layer 120.

It should be noted that the at least one groove formed in step 3 may be implemented on the substrate 110 in multiple manners. Therefore, a 3D structure of the at least one support 141 formed in step 6 is also implemented in multiple manners. For example, it may be a separate pillar or wall, or a grid-like structure crisscrossed with each other.

Step 7:
a laminated structure 150 is formed at the at least one support 141 to form a structure shown in FIG. 13. For example, a dielectric layer 151, a conductive layer 152, a dielectric layer 153, a conductive layer 154, a dielectric layer 155 and a conductive layer 156 may be sequentially deposited using a deposition process, thereby obtaining the laminated structure 150. A material of a dielectric layer in the laminated structure 150 may be: a silicon oxide, a silicon nitride, a silicon oxynitride, a metal oxide, a metal nitride, or a metal oxynitride, such as silicon dioxide, silicon nitride, or a material with a high dielectric constant, including aluminum oxide, hafnium oxide, zirconium oxide, titanium dioxide, Y₂O₃, La₂O₃, HfSiO₄, LaAlO₃, SrTiO₃, LaLuO₃, or the like; or a laminated layer or combination of one or more of the foregoing materials. A material of a conductive layer in the laminated structure 150 may be composed of a low-resistivity conductive material, such as heavily doped polysilicon, a carbon material, or various metals such as aluminum (Al), tungsten (W), copper (Cu), titanium. (Ti), tantalum (Ta), platinum (Pt), ruthenium (Ru), iridium (Ir), or rhodium (Rh), or a low-resistivity compound such as titanium nitride or tantalum nitride, or a laminated layer or combination of the foregoing several conductive materials, which is not specifically limited in the embodiment of the present application. Specific materials and layer thicknesses of the conductive layer and the dielectric layer in the laminated structure 150 may be adjusted according to needs of a capacitor, such as a capacitance value, a frequency characteristic, or the loss. Certainly, the dielectric layer in the laminated structure may further include some other material layers with high dielectric constant characteristics, which is not limited in the embodiment of the present application.

It should be noted that the at least one groove formed in step 3 is a position of the at least one support 141, and thus two ends of the laminated structure 150 will be located above a support.

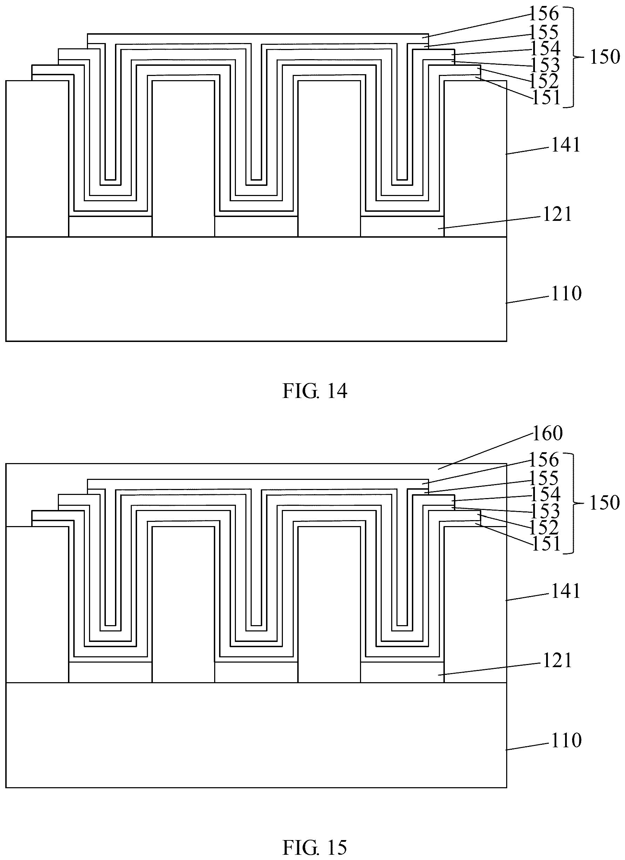

Step 8:
at least one first step and at least one second step are respectively formed at two ends of the laminated structure 150 to form a structure shown in FIG. 14. For example, steps may be formed between the conductive layer 152, the conductive layer 154 and the conductive layer 156 using a multi-step photolithography process combined with a plasma etching process.

Step 9:
an insulating layer 160 is formed on the laminated structure 150 to form a structure shown in FIG. 15. For example, the insulating layer 160 may be deposited on the laminated structure 150 using a deposition process. A material of the insulating layer 160 may be: an organic polymer material, such as polyimide, parylene, benzocyclobutene (BCB), or the like; or some inorganic materials, such as spin on glass (SOG), undoped silicon glass (USG), boro-silicate glass (BSG), phospho-silicateglass (PSG), boro-phospho-silicateglass (BPSG), a silicon oxide synthesized from tetraethyl orthosilicate (TEOS), a silicon oxide or nitride, or ceramic; or a laminated layer or combination of the foregoing materials.

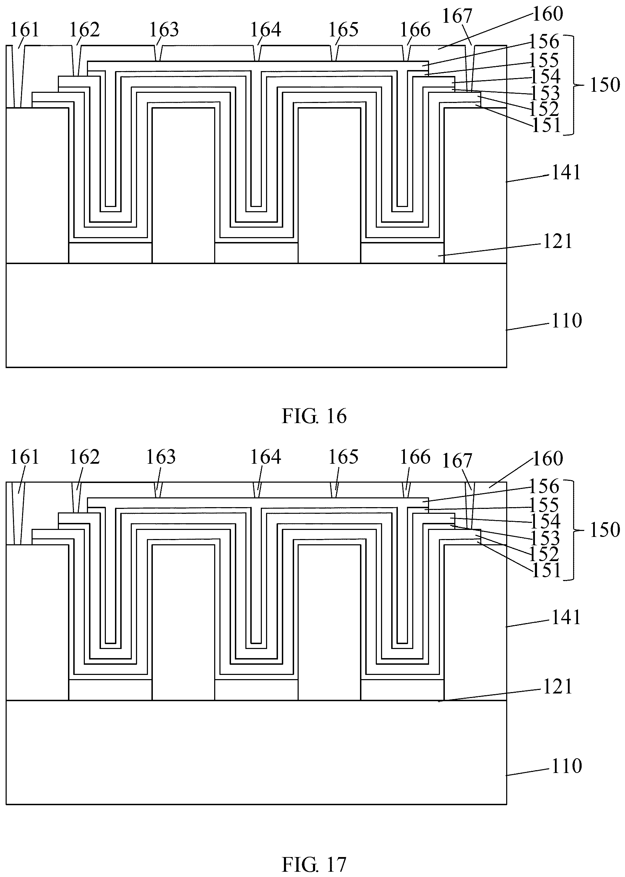

Step 10:
at least one first via and at least one second via are formed on the insulating layer 160 to form a structure shown in FIG. 16. For example, the at least one first via and the at least one second via may be produced using photolithography and etching processes. The at least one first via includes a via 161 and a via 162, the via 161 is used to expose the at least one support 141, and the second via 162 is used to expose the conductive layer 154 in the laminated structure 150. The at least one second via includes a via 163, a via 164, a via 165, a via 166, and a via 167. The via 163, the via 164, the via 165 and the via 166 are all used to expose the conductive layer 156 in the laminated structure 150, and the via 167 is used to expose the conductive layer 152 in the laminated structure 150.

Step 11:
the at least one first via and the at least one second via are filled with a conductive material to form a structure shown in FIG. 17. For example, a low-resistivity conductive material may be deposited in the at least one first via and the at least one second via using a deposition process. Further, the excess conductive material above the insulating layer 160 may be rubbed off using a surface planarization process, thereby obtaining separately independent conductive channels. A low-resistivity conductive material constituting a conductive channel includes heavily doped polysilicon, tungsten, Ti, TiN, Ta, or TaN.

Step 12:
the first electrode is formed above the at least one first via, and the second electrode is formed above the at least one second via to form a structure shown in FIG. 1. For example, a conductive material may be first deposited on the insulating layer 160 using a deposition process, and then the first electrode 171 and the second electrode 172 are formed using a photolithography process, where the first electrode 171 is electrically connected to a support on the left of four supports and the conductive layer 154 through the at least one first via, and the second electrode 172 is electrically connected to the conductive layer 152 and the conductive layer 156 through the at least one second via. Certainly, the first electrode 171 and the second electrode 172 may be produced on the insulating layer 160 using an electroplating process or a chemical plating process, which is not specifically limited in the embodiment of the present application.

In an example that the first electrode 171 and the second electrode 172 are pads, a material of the pads may be a metal material, such as copper or aluminum. Further, a low-resistivity Ti, TiN, Ta, or TaN layer may be provided between a pad and an ILD as an adhesion layer and/or a barrier layer. Further, surfaces of the pads may be further provided with a metal layer for subsequent wire bonding or welding processes. For example, a material of the metal layer may be Ni, Pd, Au, Sn, Ag, or the like.

It should be noted that, in step 10, a region where the at least one first via is located and a region where the at least one second via is located may not overlap to ensure that the first electrode 171 and the second electrode 172 are separately provided.

It should be understood that the etching process may include at least one of:
a dry etching process, a wet etching process or a laser etching process.

Further, the dry etching process may include at least one of: reactive ion etching, plasma etching, ion beam etching, or the like. Preferably, an etching speed may be changed by changing a mixing ratio of an etching gas. A chemical raw material of the wet etching process may include, but is not limited to, an etching solution containing hydrofluoric acid. In some embodiments of the present application, an etched shape, flatness of a bottom surface, or the like could be effectively ensured using an etching method of combining dry etching and wet etching or a method of combining laser etching and wet etching.

The deposition process includes, but is not limited to:
a physical vapor deposition (PVD) process and/or a chemical vapor deposition (CVD) process, for example, thermal oxidation, plasma enhanced chemical vapor deposition (PECVD), low pressure chemical vapor deposition (LPCVD), atomic layer deposition (ALD) ), spin-coating or spraying.

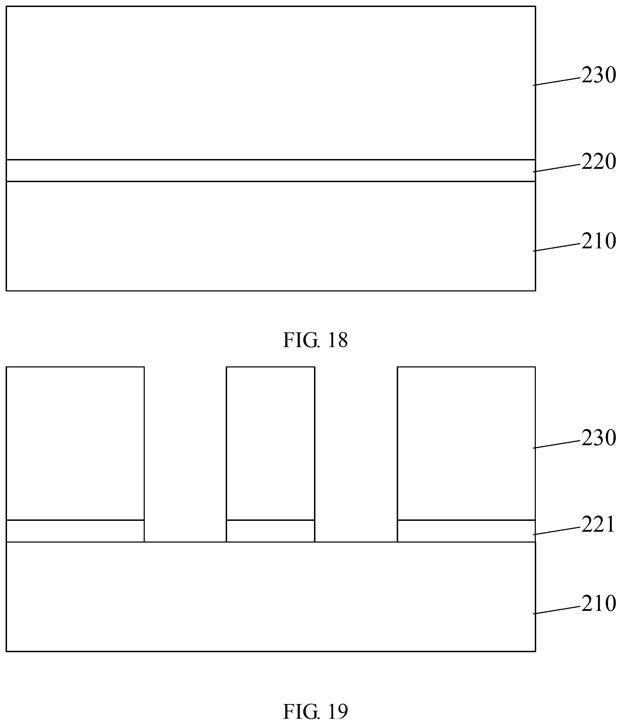

A method for producing the foregoing capacitor 200 will be described in detail hereinafter with reference to FIG. 18 to FIG. 27. It should be understood that the producing methods for the capacitor 100 and the capacitor 200 are similar. To avoid repetition, only a producing flow will be described here, and specific processes and specific materials used may refer to the corresponding contents of producing the capacitor 100.

The method for producing the capacitor 200 may include some or all of the following steps.

Step 0:
a substrate 210 is first selected, a base layer 220 is next formed on the substrate 210, and then the molding layer 230 is formed on the base layer 220 to form a structure shown in FIG. 18.

Step 1:
two grooves penetrating the molding layer 230 and the base layer 220 are formed to form a structure shown in FIG. 19.

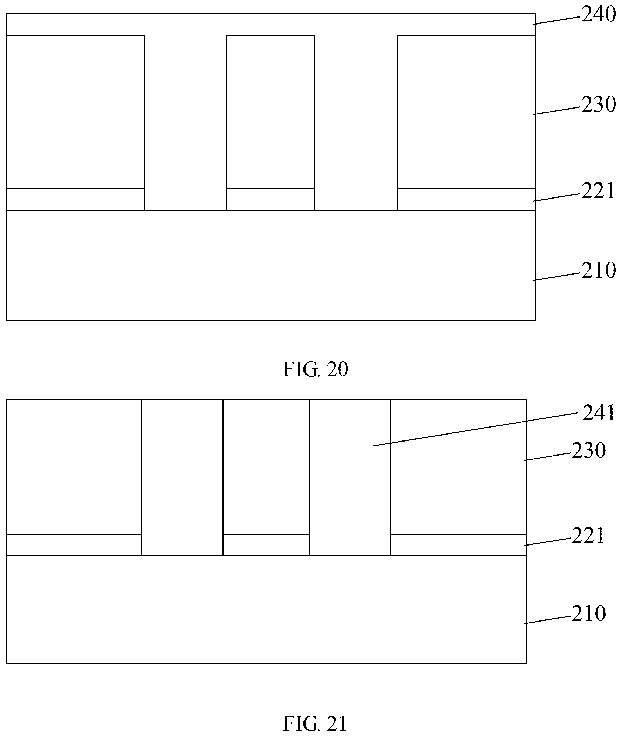

Step 2:
the two grooves are filled with a conductive material 240 to form a structure shown in FIG. 20.

Step 3:
a conductive material 240 above the molding layer 230 is removed to form a structure shown in FIG. 21.

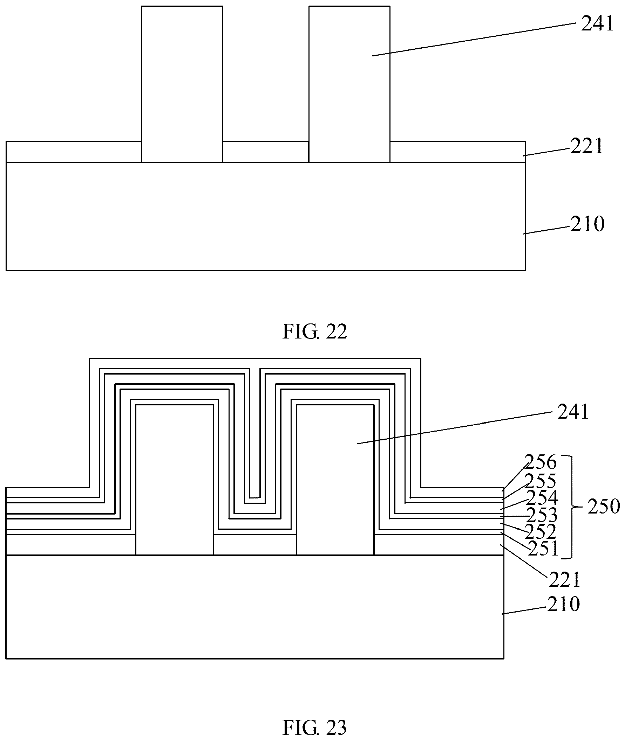

Step 4:
the molding layer 230 above the substrate 210 is removed to form two supports 241, thereby forming a structure shown in FIG. 22.

Step 5:
a laminated structure 250 is formed at the two supports 241 to form a structure shown in FIG. 23.

It should be noted that the two grooves formed in step 1 are positions of the two supports 241 (located in the middle of the substrate 210), and the base layer 221 is located above edges of the substrate 210. Therefore, in step 5, after the molding layer is removed, two ends of the laminated structure 250 are located on the base layer 221.

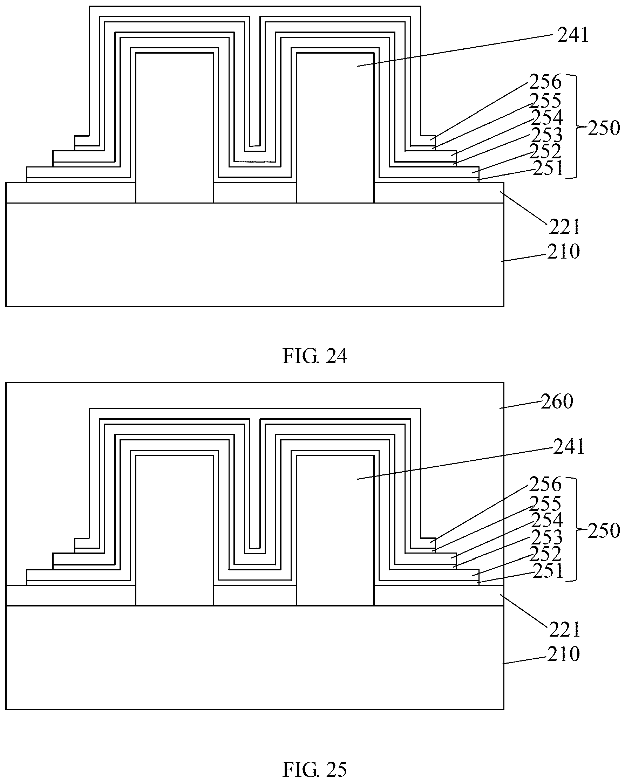

Step 6:
at least one first step and at least one second step are respectively formed at two ends of the laminated structure 250 to form a structure shown in FIG. 24.

Step 7:
an insulating layer 260 is formed on the laminated structure 250 to form a structure shown in FIG. 25.

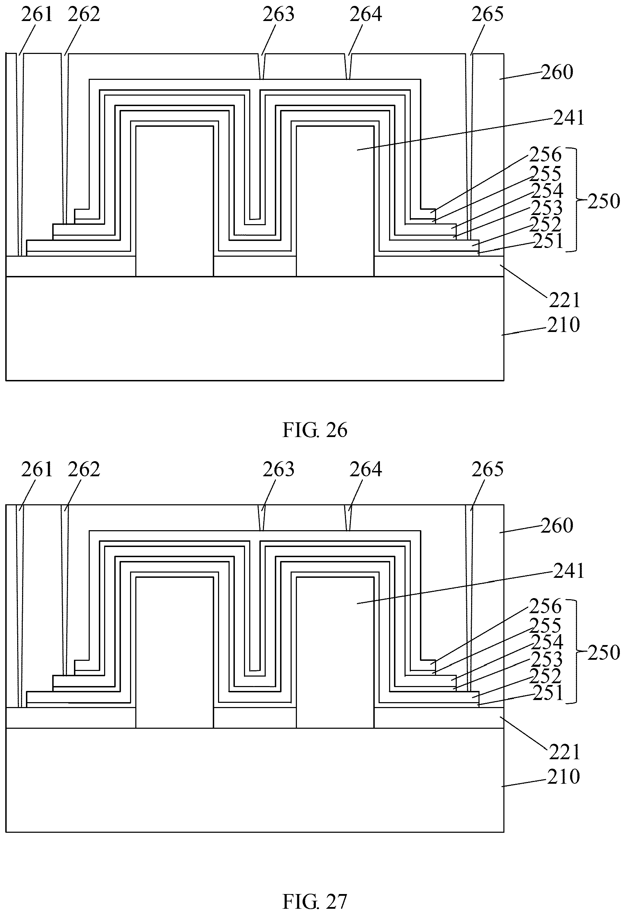

Step 8:
at least one first via (that is, a via 261 and a via 262) and at least one second via (that is, a via 263, a via 264 and a via 265) are formed on the insulating layer 260 to form a structure shown in FIG. 26.

Step 9:
the at least one first via and the at least one second via are filled with a conductive material to form a structure shown in FIG. 27.

Step 10:
the first electrode is formed above the at least one first via, and the second electrode is formed above the at least one second via to form a structure shown in FIG. 4.

It should be understood that FIG. 6 to FIG. 29 are merely examples of the present application and should not be understood as a limitation on the present application.

For example, in other alternative embodiments, the producing process of the foregoing base layer may be directly omitted. That is, a molding layer is directly deposited on a substrate.

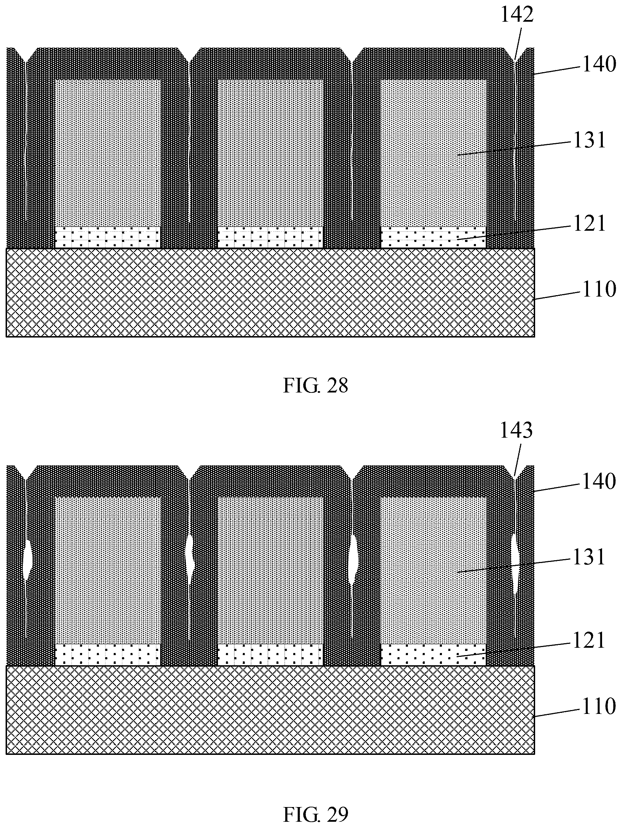

For another example, alternatively, TiN may be deposited into grooves shown in FIG. 9 or FIG. 19 using an ALD process. In this case, there may be small slits (as shown in FIG. 28) or voids (as shown in FIG. 29) inside the filled grooves.

For another example, a variation structure of the capacitor 100 or the capacitor 200 may be produced using a similar producing process. Details are not described redundantly herein to avoid repetition.

The present application further provides a capacitor produced according to the foregoing producing method.

It should be understood that method embodiments and product embodiments may correspond to each other, and similar descriptions may refer to the product embodiments. Details are not described redundantly herein for brevity.

It should also be understood that each embodiment of the method 300 for producing a capacitor listed above may be performed by a robot or a numerical control machine. The device software or process for performing the method 300 may perform the foregoing method 300 by executing the computer program code stored in the memory.

It should be understood that sequence numbers of the foregoing processes do not mean execution sequences in various embodiments of the present application. The execution sequences of the processes should be determined according to functions and internal logic of the processes, and should not be construed as any limitation on the implementation processes of the embodiments of the present application.

A person of ordinary skill in the art may be aware that, various exemplary producing methods described in conjunction with the embodiments disclosed herein may be implemented by electronic hardware or a combination of computer software and electronic hardware. Whether these functions are executed in hardware or software mode depends on a particular application and a design constraint condition of the technical solutions. Persons skilled in the art may use different methods to implement the described functions for each particular application.

In the several embodiments provided in the present application, it should be understood that the disclosed integrated apparatus, components in the integrated apparatus and methods for producing the integrated apparatus may be implemented in other manners. For example, the integrated apparatus embodiments described above are merely exemplary. For example, division of the layers is merely logical function division and there may be other division manners in practical implementation. For example, multiple layers or devices may be combined or integrated, for example, the upper plate and the active material layer may be combined into one layer, or some features (such as the active material layer) may be ignored or not produced.

Described above is merely the specific embodiments of the present disclosure, whereas the protection scope of the present application is not limited to this. Any person who is skilled in and familiar with the present technical field may readily conceive of variations or substitutions within the technical scope disclosed by the present application. Therefore, the protection scope of the present application shall be subject to the protection scope of the claims.

## Claims

1. A capacitor (100), comprising:
a first electrode (171) and a second electrode (172) respectively configured to connect an external circuit;
at least one support (141), the at least one support (141) being a wall-shaped structure;
a laminated structure (150) comprising at least one dielectric layer (151, 153, 155) and at least one conductive layer (152, 154, 156); the at least one dielectric layer (151, 153, 155) and the at least one conductive layer (152, 154, 156) covering the at least one support (141), and the at least one dielectric layer (151, 153, 155)and the at least one conductive layer (152, 154, 156) forming a structure that a dielectric layer and a conductive layer are adjacent to each other; and
an interconnection structure configured to electrically connect the first electrode (171) to the at least one support (141) or a first conductive layer of the at least one conductive layer (152, 154, 156), and to electrically connect the second electrode (172) to a second conductive layer of the at least one conductive layer, wherein the second conductive layer is connected to the at least one support or the first conductive layer which is electrically connected to the first electrode (171), and the second conductive layer and the support or the first conductive layer are separated by a dielectric layer of the at least one dielectric layer; and
a base layer (121), the base layer (121) and the at least one support (141) forming at least one groove structure, the base layer (121) serving as a bottom of the at least one groove structure, the at least one support (141) serving as a side wall of the at least one groove structure, and the laminated structure (150) covering the at least one groove structure;
the base layer (121) is provided with at least one opening, the at least one support (141) is provided in the at least one opening, and a lower surface of the base layer (121) and a lower surface of the at least one support (141) are located in a same plane.

2. The capacitor (100) according to claim 1, wherein the at least one support (141) is a plurality of conductive supports electrically connected to each other.

3. The capacitor (100) according to claim 2, wherein bottoms of the plurality of supports (141) are electrically connected through a conductive layer, or the plurality of supports (141) form a grid structure.

4. The capacitor (100) according to claim 2 or 3, wherein the plurality of supports (141) are distributed in an array.

5. The capacitor (100) according to any one of claims 1 to 4, wherein at least one first step and at least one second step are respectively formed at two ends of the laminated structure (150).

6. The capacitor (100) according to claim 5, wherein the two ends of the laminated structure (150) are provided above the at least one support (141) or respectively provided on two sides of the at least one support (141).

7. The capacitor (100) according to any one of claims 1 to 6, wherein a material of the base layer is an insulating material.

8. The capacitor (100) according to any one of claims 1 to 7, wherein the capacitor (100) further comprises:
an insulating layer (160) provided above the laminated structure (150) and under the first electrode (171) and the second electrode (172), the interconnection structure being provided in the insulating layer (160), the interconnection structure comprises at least one first via and at least one second via formed in the insulating layer (160), the first electrode (171) is electrically connected to the at least one support (141) or the first conductive layer through the at least one first via, and the second electrode is electrically connected to the second conductive layer through the at least one second via.

9. The capacitor (100) according to any one of claims 1 to 8, wherein the capacitor (100) further comprises:
a substrate (110) provided under the laminated structure (150), the substrate (110) is a wafer with a resistivity lower than a preset threshold value.

10. The capacitor (100) according to claim 1, wherein the interconnection structure is specifically configured to electrically connect the first electrode (171) to some or all even-numbered conductive layers in the laminated structure (150), and to electrically connect the second electrode (172) to some or all odd-numbered conductive layers in the laminated structure (150).

11. A method for producing a capacitor (100) according to any one of claims 1-10, comprising:
forming the base layer (121) on the substrate (110), producing the at least one support (141) on the base layer (121), the at least one support (141) being a pillar-shaped structure or a wall-shaped structure;
forming the at least one opening in the base layer (121), the at least one support (141) is provided in the at least one opening, and a lower surface of the base layer (121) and a lower surface of the at least one support (141) are located in a same plane;
producing at least one dielectric layer and at least one conductive layer on the at least one support to obtain the laminated structure (150), wherein the at least one dielectric layer and the at least one conductive layer form a structure that a dielectric layer and a conductive layer are adjacent to each other;
producing an insulating structure comprising the interconnection structure on the laminated structure (150); and
producing the first electrode (171) and the second electrode (172) on the insulating structure, wherein the first electrode (171) is electrically connected to the first conductive layer of the at least one conductive layer through the first interconnection structure, and the second electrode (172) is electrically connected to the second conductive layer of the at least one conductive layer through the second interconnection structure; and the second conductive layer is connected to the first conductive layer, and the first conductive layer and the second conductive layer are separated by a dielectric layer of the at least one dielectric layer.

12. The method according to claim 11, wherein the producing the at least one support (141) on the substrate (110) comprises:
forming a molding layer on the substrate (110);
forming at least one groove penetrating the molding layer;
filling the at least one groove in the molding layer with a conductive material;
removing a conductive material above the molding layer; and
removing the molding layer above the substrate (110) to form the at least one support (141) on the substrate (110).

## Patentansprüche

1. Kondensator (100), umfassend:
eine erste Elektrode (171) und eine zweite Elektrode (172), jeweils dazu konfiguriert, eine externe Schaltung zu verbinden;
mindestens eine Stütze (141), wobei die mindestens eine Stütze (141) eine wandförmige Struktur ist;
eine laminierte Struktur (150), umfassend mindestens eine dielektrische Schicht (151, 153, 155) und mindestens eine leitfähige Schicht (152, 154, 156); wobei die mindestens eine dielektrische Schicht (151, 153, 155) und die mindestens eine leitfähige Schicht (152, 154, 156) die mindestens eine Stütze (141) bedecken und die mindestens eine dielektrische Schicht (151, 153, 155) und die mindestens eine leitfähige Schicht (152, 154, 156) eine Struktur ausbilden, wobei eine dielektrische Schicht und eine leitfähige Schicht aneinander angrenzen; und
eine Verbindungsstruktur, dazu konfiguriert, die erste Elektrode (171) elektrisch mit der mindestens einen Stütze (141) oder einer ersten leitfähigen Schicht der mindestens einen leitfähigen Schicht (152, 154, 156) zu verbinden, und die zweite Elektrode (172) elektrisch mit einer zweiten leitfähigen Schicht der mindestens einen leitfähigen Schicht zu verbinden, wobei die zweite leitfähige Schicht mit der mindestens einen Stütze oder der ersten leitfähigen Schicht verbunden ist, die elektrisch mit der ersten Elektrode (171) verbunden ist, und die zweite leitfähige Schicht und die Stütze oder die erste leitfähige Schicht durch eine dielektrische Schicht der mindestens einen dielektrischen Schicht getrennt sind; und
eine Basisschicht (121), wobei die Basisschicht (121) und die mindestens eine Stütze (141) mindestens eine Nutenstruktur ausbilden, wobei die Basisschicht (121) als Boden der mindestens einen Nutenstruktur dient, wobei die mindestens eine Stütze (141) als Seitenwand der mindestens einen Nutenstruktur dient, und wobei die laminierte Struktur (150) die mindestens eine Nutenstruktur bedeckt;
die Basisschicht (121) mit mindestens einer Öffnung versehen ist, die mindestens eine Stütze (141) in der mindestens einen Öffnung bereitgestellt ist, und eine untere Oberfläche der Basisschicht (121) und eine untere Oberfläche der mindestens einen Stütze (141) in einer gleichen Ebene angeordnet sind.

2. Kondensator (100) nach Anspruch 1, wobei die mindestens eine Stütze (141) eine Vielzahl von leitfähigen Stützen ist, die elektrisch miteinander verbunden sind.

3. Kondensator (100) nach Anspruch 2, wobei Böden der Vielzahl von Stützen (141) durch eine leitfähige Schicht elektrisch verbunden sind oder die Vielzahl von Stützen (141) eine Gitterstruktur ausbildet.

4. Kondensator (100) nach Anspruch 2 oder 3, wobei die Vielzahl von Stützen (141) in einem Array verteilt ist.

5. Kondensator (100) nach einem der Ansprüche 1 bis 4, wobei mindestens eine erste Stufe und mindestens eine zweite Stufe jeweils an zwei Enden der laminierten Struktur (150) ausgebildet sind.

6. Kondensator (100) nach Anspruch 5, wobei die zwei Enden der laminierten Struktur (150) über der mindestens einen Stütze (141) oder jeweils auf zwei Seiten der mindestens einen Stütze (141) bereitgestellt sind.

7. Kondensator (100) nach einem der Ansprüche 1 bis 6, wobei ein Material der Basisschicht ein Isoliermaterial ist.

8. Kondensator (100) nach einem der Ansprüche 1 bis 7, wobei der Kondensator (100) ferner Folgendes umfasst:
eine Isolierschicht (160), bereitgestellt über der laminierten Struktur (150) und unter der ersten Elektrode (171) und der zweiten Elektrode (172), wobei die Verbindungsstruktur in der Isolierschicht (160) bereitgestellt ist, wobei die Verbindungsstruktur mindestens eine erste Durchkontaktierung und mindestens eine zweite Durchkontaktierung umfasst, die in der Isolierschicht (160) ausgebildet sind, die erste Elektrode (171) elektrisch mit der mindestens einen Stütze (141) oder der ersten leitfähige Schicht durch die mindestens eine erste Durchkontaktierung verbunden ist, und die zweite Elektrode elektrisch mit der zweiten leitfähigen Schicht durch die mindestens eine zweite Durchkontaktierung verbunden ist.

9. Kondensator (100) nach einem der Ansprüche 1 bis 8, wobei der Kondensator (100) ferner Folgendes umfasst:
ein Substrat (110), bereitgestellt unter der laminierten Struktur (150), wobei das Substrat (110) ein Wafer mit einem spezifischen Widerstand ist, der niedriger als ein voreingestellter Schwellenwert ist.

10. Kondensator (100) nach Anspruch 1, wobei die Verbindungsstruktur spezifisch konfiguriert ist zum elektrischen Verbinden der erste Elektrode (171) mit einigen oder allen geradzahligen leitfähigen Schichten in der laminierten Struktur (150) und zum elektrischen Verbinden der zweiten Elektrode (172) mit einigen oder allen ungeradzahligen leitfähigen Schichten in der laminierten Struktur (150).

11. Verfahren zum Erzeugen eines Kondensators (100) nach einem der Ansprüche 1-10, umfassend:
Ausbilden der Basisschicht (121) auf dem Substrat (110), Erzeugen der mindestens einen Stütze (141) auf der Basisschicht (121), wobei die mindestens eine Stütze (141) eine säulenförmige Struktur oder eine wandförmige Struktur ist;
Ausbilden der mindestens einen Öffnung in der Basisschicht (121), wobei die mindestens eine Stütze (141) in der mindestens einen Öffnung bereitgestellt ist, und eine untere Oberfläche der Basisschicht (121) und eine untere Oberfläche der mindestens einen Stütze (141) in einer gleichen Ebene angeordnet sind;
Erzeugen mindestens einer dielektrischen Schicht und mindestens einer leitfähigen Schicht auf der mindestens einen Stütze, um die laminierte Struktur (150) zu erhalten, wobei die mindestens eine dielektrische Schicht und die mindestens eine leitfähige Schicht eine Struktur ausbilden, wobei eine dielektrische Schicht und a leitfähige Schicht aneinander angrenzen;
Erzeugen einer isolierenden Struktur, die die Verbindungsstruktur auf der laminierten Struktur (150) umfasst; und
Erzeugen der ersten Elektrode (171) und der zweiten Elektrode (172) auf der isolierenden Struktur, wobei die erste Elektrode (171) elektrisch mit der ersten leitfähigen Schicht der mindestens einen leitfähigen Schicht durch die erste Verbindungsstruktur verbunden ist, und die zweite Elektrode (172) elektrisch mit der zweiten leitfähigen Schicht der mindestens einen leitfähigen Schicht durch die zweite Verbindungsstruktur verbunden ist; und die zweite leitfähige Schicht mit der ersten leitfähigen Schicht verbunden ist und die erste leitfähige Schicht und die zweite leitfähige Schicht durch eine dielektrische Schicht der mindestens einen dielektrischen Schicht getrennt sind.

12. Verfahren nach Anspruch 11, wobei das Fertigen der mindestens einen Stütze (141) auf dem Substrat (110) Folgendes umfasst:
Ausbilden einer Formschicht auf dem Substrat (110);
Ausbilden mindestens einer Nut, die die Formschicht durchdringt;
Füllen der mindestens einen Nut in der Formschicht mit einem leitfähigen Material;
Entfernen eines leitfähigen Materials über der Formschicht; und
Entfernen der Formschicht über dem Substrat (110), um die mindestens eine Stütze (141) auf dem Substrat (110) auszubilden.

## Revendications

1. Condensateur (100), comprenant :
une première électrode (171) et une deuxième électrode (172) respectivement configurées pour connecter un circuit externe ;
au moins un support (141), l'au moins un support (141) étant une structure en profil de paroi ;
une structure stratifiée (150) comprenant au moins une couche diélectrique (151, 153, 155) et au moins une couche conductrice (152, 154, 156) ; l'au moins une couche diélectrique (151, 153, 155) et l'au moins une couche conductrice (152, 154, 156) recouvrant l'au moins un support (141), et l'au moins une couche diélectrique (151, 153, 155) et l'au moins une couche conductrice (152, 154, 156) formant une structure où une couche diélectrique et une couche conductrice sont adjacentes l'une à l'autre ; et
une structure d'interconnexion configurée pour connecter électriquement la première électrode (171) à l'au moins un support (141) ou à une première couche conductrice de l'au moins une couche conductrice (152, 154, 156), et pour connecter électriquement la deuxième électrode (172) à une deuxième couche conductrice de l'au moins une couche conductrice, la deuxième couche conductrice étant connectée à l'au moins un support ou à la première couche conductrice qui est électriquement connectée à la première électrode (171), et la deuxième couche conductrice et le support ou la première couche conductrice étant séparés par une couche diélectrique de l'au moins une couche diélectrique ; et
une couche de base (121), la couche de base (121) et l'au moins un support (141) formant au moins une structure de rainure, la couche de base (121) servant de dessous de l'au moins une structure de rainure, l'au moins un support (141) servant de paroi latérale de l'au moins une structure de rainure, et la structure stratifiée (150) recouvrant l'au moins une structure de rainure ;
la couche de base (121) est pourvue d'au moins une ouverture, l'au moins un support (141) est fourni dans l'au moins une ouverture, et une surface inférieure de la couche de base (121) et une surface inférieure de l'au moins un support (141) sont situées sur un même plan.

2. Condensateur (100) selon la revendication 1, dans lequel l'au moins un support (141) est une pluralité de supports conducteurs connectés électriquement les uns aux autres.

3. Condensateur (100) selon la revendication 2, dans lequel les dessous de la pluralité de supports (141) sont électriquement connectés par le biais d'une couche conductrice, ou la pluralité de supports (141) forment une structure de grille.

4. Condensateur (100) selon la revendication 2 ou la revendication 3, dans lequel la pluralité de supports (141) sont répartis en un réseau.

5. Condensateur (100) selon l'une quelconque des revendications 1 à 4, dans lequel au moins un premier pas et au moins un deuxième pas sont respectivement formés au niveau de deux extrémités de la structure stratifiée (150).

6. Condensateur (100) selon la revendication 5, dans lequel les deux extrémités de la structure stratifiée (150) sont fournies au-dessus de l'au moins un support (141) ou respectivement fournies sur deux côtés de l'au moins un support (141).

7. Condensateur (100) selon l'une quelconque des revendications 1 à 6, dans lequel un matériau de la couche de base est un matériau isolant.

8. Condensateur (100) selon l'une quelconque des revendications 1 à 7, dans lequel le condensateur (100) comprend en outre :
une couche isolante (160) fournie au-dessus de la structure stratifiée (150) et sous la première électrode (171) et la deuxième électrode (172), la structure d'interconnexion étant fournie dans la couche isolante (160), la structure d'interconnexion comprend au moins un premier trou d'interconnexion et au moins un deuxième trou d'interconnexion formés dans la couche isolante (160), la première électrode (171) est électriquement connectée à l'au moins un support (141) ou à la première couche conductrice par le biais de l'au moins un premier trou d'interconnexion, et la deuxième électrode est électriquement connectée à la deuxième couche conductrice par le biais de l'au moins un deuxième trou d'interconnexion.

9. Condensateur (100) selon l'une quelconque des revendications 1 à 8, le condensateur (100) comprenant en outre :
un substrat (110) fourni sous la structure stratifiée (150), le substrat (110) est une tranche ayant une résistivité inférieure à une valeur seuil prédéfinie.

10. Condensateur (100) selon la revendication 1, dans lequel la structure d'interconnexion est spécifiquement configurée pour connecter électriquement la première électrode (171) à certaines, ou à toutes les, couches conductrices paires dans la structure stratifiée (150), et pour connecter électriquement la deuxième électrode (172) à certaines, ou à toutes, les couches conductrices impaires dans la structure stratifiée (150) .

11. Procédé de production d'un condensateur (100) selon l'une quelconque des revendications 1 à 10, comprenant :
la formation de la couche de base (121) sur le substrat (110), la production de l'au moins un support (141) sur la couche de base (121), l'au moins un support (141) étant une structure en profil de pilier ou une structure en profil de paroi ;
la formation de l'au moins une ouverture dans la couche de base (121), l'au moins un support (141) est fourni dans l'au moins une ouverture, et une surface inférieure de la couche de base (121) et une surface inférieure de l'au moins un support (141) sont situées sur un même plan ;
la production d'au moins une couche diélectrique et d'au moins une couche conductrice sur l'au moins un support pour obtenir la structure stratifiée (150), l'au moins une couche diélectrique et l'au moins une couche conductrice formant une structure où une couche diélectrique et une couche conductrice sont adjacentes l'une à l'autre ;
la production d'une structure isolante comprenant la structure d'interconnexion sur la structure stratifiée (150) ; et
la production de la première électrode (171) et de la deuxième électrode (172) sur la structure isolante, la première électrode (171) étant électriquement connectée à la première couche conductrice de l'au moins une couche conductrice par le biais de la première structure d'interconnexion, et la deuxième électrode (172) étant électriquement connectée à la deuxième couche conductrice de l'au moins une couche conductrice par le biais de la deuxième structure d'interconnexion ; et la deuxième couche conductrice étant connectée à la première couche conductrice, et la première couche conductrice et la deuxième couche conductrice étant séparées par une couche diélectrique de l'au moins une couche diélectrique.

12. Procédé selon la revendication 11, dans lequel la production de l'au moins un support (141) sur le substrat (110) comprend :
la formation d'une couche de moulage sur le substrat (110) ;
la formation d'au moins une rainure pénétrant dans la couche de moulage ;
le remplissage de l'au moins une rainure dans la couche de moulage avec un matériau conductrice ;
le retrait d'un matériau conducteur au-dessus de la couche de moulage ; et
le retrait de la couche de moulage au-dessus du substrat (110) pour former l'au moins un support (141) sur le substrat (110).
